# DEMANDE DE BREVET EUROPEEN

(11) **EP 1 962 156 A1**
(43) Date de publication de la demande: **27.08.2008**
(21) Numéro de dépôt: 07102860.9
(22) Date de dépôt: 22.02.2007
(51) Int. Cl.: G04G 1/02, G04D 7/00, G11C 16/10, G11C 16/22

(54) **Procédure d'accès d'une mémoire non volatile pour montre**

(71) Demandeur: EM Microelectronic-Marin SA, 2074 Marin (CH)
(72) Inventeur: Novac, Pinchas, 2000, Neuchâtel (CH)
(74) Mandataire: Vigand, Philippe

(57) **Abrégé**

L'invention concerne une procédure d'accès à une mémoire non volatile pour montre, la montre comprenant deux bornes d'alimentation accessibles depuis l'extérieur, qui définissent une différence de potentiel correspondant à une tension d'alimentation courante, et un circuit de commande de la mémoire non volatile réalisé dans une technologie supportant une tension d'alimentation maximale prédéfinie, la procédure d'accès consistant à transmettre au circuit de commande de la mémoire non volatile par le biais d'une borne d'alimentation de la montre: (a) une clé d'ouverture pour autoriser l'accès à la mémoire non volatile; (b) une instruction d'accès à la mémoire non volatile; la procédure étant caractérisée en ce que la clé d'ouverture est une instruction prédéfinie transmise par modulation de la tension d'alimentation courante de sorte que cette dernière n'excède pas la tension d'alimentation maximale prédéfinie.

## Description

### DOMAINE TECHNIQUE

La présente invention concerne, de manière générale, une procédure d'accès d'une mémoire non volatile pour montre. La montre comprend deux bornes d'alimentation accessibles depuis l'extérieur de la montre, qui définissent une différence de potentiel correspondant à une tension d'alimentation courante. L'invention concerne plus particulièrement la procédure d'accès à la mémoire non volatile par le biais d'au moins une des bornes d'alimentation en vue d'y programmer par exemple des valeurs pour la bonne marche de la montre.

### ARRIERE-PLAN TECHNOLOGIQUE

Il est connu dans l'art antérieur, par exemple du document CH 664 868, une méthode de programmation d'une mémoire non volatile pour montre analogique permettant de régler par exemple la valeur d'inhibition pour ajuster la fréquence de la base de temps de la montre. La méthode décrite dans ce document ne nécessite aucune entrée auxiliaire et n'utilise que les seules bornes de la pile d'alimentation accessibles depuis l'extérieur dans ce genre de montre. On comprend l'avantage d'un tel système qui permet de régler des valeurs telle que la marche de la montre, de manière juste, lorsque cette dernière a été scellée et est non démontable et donc n'est plus sujette à des perturbations dues par exemple au soudage de la glace ou à toute autre étape de fabrication postérieure au réglage.

Pour mettre en oeuvre une telle méthode de programmation, un circuit intégré de commande de la mémoire non volatile est incorporé dans la montre. La méthode de programmation prévoit de porter la tension d'alimentation à une valeur élevée de tension par le biais d'un pic de tension, i.e. 6,3 V, pour autoriser l'accès à la mémoire non volatile, avant de transmettre une instruction de programmation au moyen d'impulsions fournies sur une borne de l'alimentation permettant de modifier le contenu de compteurs jusqu'à atteindre la valeur désirée avant la recopie dans la mémoire non volatile.

Une telle méthode bien que fonctionnelle présente un certain nombre d'inconvénients. L'un des soucis permanents pour l'homme du métier est la miniaturisation des composants d'une montre pour en réduire la taille globale en vue d'obtenir un meilleur effet esthétique de l'ensemble. Un des composants principaux sur lesquels des progrès sont régulièrement accomplis est le circuit intégré incorporé dans la montre. En effet, les technologies utilisées de fabrication des transistors sont de plus en plus concentrées et entraînent des modifications du comportement global du circuit intégré. Ainsi plus la technologie des transistors est fine ou petite, plus les tensions applicables pour commander de tels transistors doivent être basses au risque d'avoir sinon un comportement non maîtrisable et/ou désirable des transistors. Pour une certaine technologie de transistors, la tension de commande maximale applicable entre ses bornes est définie, par exemple à 3,6 Volts pour une technologie dite "0,35µ", i.e. dont la taille d'un transistor fait 0,35 µm, et par conséquent l'application de tensions de commande plus élevée sur des transistors fabriqués dans cette technologie entraînent une dégradation de la fiabilité des transistors et donc du fonctionnement global du circuit. Bien évidemment, une telle incertitude ne peut être tolérée pour une méthode de programmation d'une mémoire de non volatile d'une montre dans laquelle on veut programmer des valeurs assurant la bonne marche de la montre au moyen notamment d'un circuit intégré de commande.

### RESUME DE L'INVENTION

Le but principal de la présente invention est de développer une procédure d'accès d'une mémoire non volatile pour montre, indépendante de la technologie de transistors utilisée dans le circuit de commande de la mémoire de la montre. Pour cela, la montre comprend, en outre de la mémoire non volatile, deux bornes d'alimentation accessibles depuis l'extérieur, qui définissent une différence de potentiel correspondant à une tension d'alimentation courante, et un circuit de commande de la mémoire non volatile réalisé dans une technologie supportant une tension d'alimentation maximale prédéfinie. La procédure d'accès consiste à transmettre au circuit de commande de la mémoire non volatile par le biais d'au moins une des bornes d'alimentation de la montre:
a) une clé d'ouverture pour autoriser l'accès à la mémoire non volatile;
b) une instruction d'accès de la mémoire non volatile;

La procédure d'accès est caractérisée en ce que la clé d'ouverture est une instruction prédéfinie transmise par modulation de la tension d'alimentation courante de sorte que cette dernière n'excède pas la tension d'alimentation maximale prédéfinie.

L'utilisation d'une telle clé d'ouverture, sous la forme d'une instruction prédéfinie, assure que la différence de potentiel entre les bornes d'alimentation reste toujours inférieure à la tension d'alimentation maximale prédéfinie en fonction de la technologie du circuit de commande. Ainsi, on évite de dégrader la fiabilité du circuit à cause d'une tension de commande trop élevée sur les transistors constituant le circuit de commande de la mémoire non volatile. En outre, le caractère prédéfini de l'instruction servant de clé d'ouverture garantit un accès sécurisé à la mémoire.

Des modes de réalisation avantageux font l'objet des revendications dépendantes.

### BREVE DESCRIPTION DES FIGURES

D'autres caractéristiques et avantages de la présente invention apparaîtront plus clairement à la lecture de la description détaillée qui suit de modes de réalisation de l'invention donnés uniquement à titre d'exemple non limitatif et illustrés par les dessins annexés où :
- la figure 1 représente un exemple de modulation de largeur d'impulsion utilisée dans la procédure d'accès d'une mémoire non volatile pour montre selon un mode de mise en oeuvre préféré de l'invention;
- les figures 2a et 2b représentent respectivement une instruction de programmation et la variation de courant correspondante pour vérifier l'exécution de l'instruction de programmation;
- les figures 3a et 3b représentent respectivement une instruction de lecture et les variations de courant correspondantes pour lire les données;
- la figure 4 représente de manière schématique une montre analogique sur laquelle est mise en oeuvre la procédure d'accès selon l'invention.
- la figure 5 représente de manière schématique un circuit de commande de la mémoire non volatile incorporé dans une montre;

### DESCRIPTION DETAILLEE DE L'INVENTION

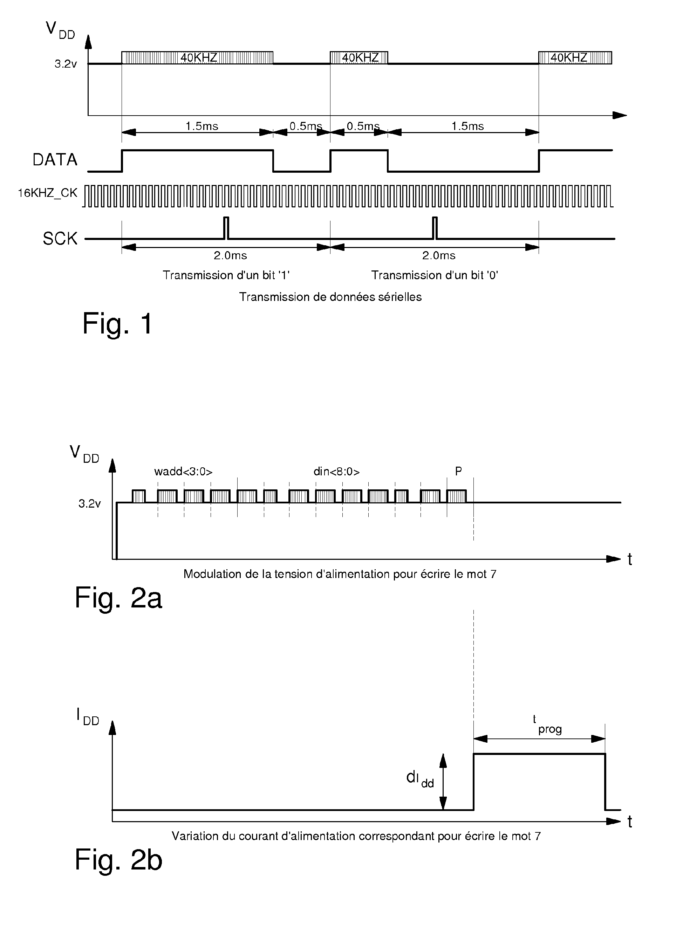

La présente invention, qui va maintenant être présentée, est donnée à titre purement illustratif et non limitatif en relation avec les figures 1 à 4.

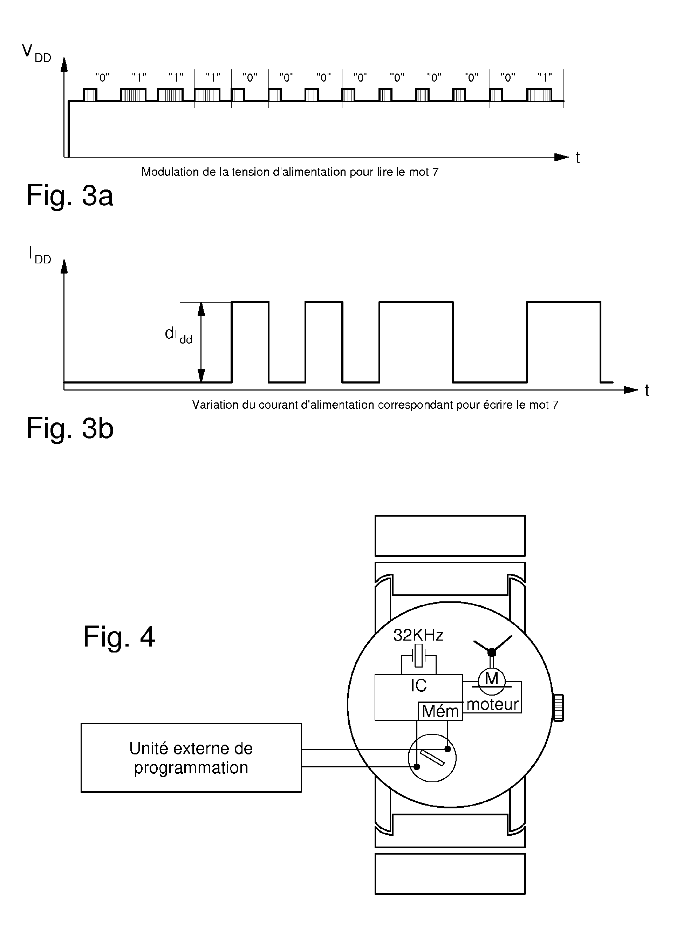

La figure 4 représente de manière schématique une montre analogique comprenant un résonateur à quartz délivrant une fréquence de 32 KHz, des moyens diviseurs de fréquence pour commander à la fréquence désirée la marche d'un moteur entraînant les aiguilles, et alimentée par une pile connectée à deux bornes d'alimentation accessibles depuis l'extérieur, généralement par le fond du boîtier de la montre. Il est en outre prévu une mémoire non volatile pour stocker des informations relatives de manière générale à la montre et plus particulièrement à la bonne marche de celle-ci et un circuit intégré de commande de la mémoire pour y accéder. Le circuit de commande de la mémoire non volatile est réalisé dans une technologie supportant une tension d'alimentation maximale prédéfinie. Parmi les informations possibles que peut contenir cette mémoire non volatile, on trouve par exemple la période d'inhibition et l'inhibition du résonateur à quartz, la durée des impulsions motrices, la période du moteur, l'activation ou la désactivation de la détection de fin de vie de la batterie, le choix du type de batterie utilisable, le numéro de série unique du circuit intégré utilisé, etc.

Pour programmer ces différentes informations dans la mémoire non volatile de la montre, il est prévu une procédure d'accès sécurisée après l'assemblage de la montre de manière à ce que les informations influençables par le procédé d'assemblage telle que le réglage de la marche de la montre ou les réglages moteurs (durée d'impulsion, entre les impulsions...) par exemple, soient les plus fiables possibles. Cette procédure d'accès de la mémoire non volatile s'effectue par la transmission d'instructions au circuit de commande de la mémoire via au moins une des bornes d'alimentation de la montre. On notera à cet effet que les deux bornes d'alimentation définissent une différence de potentiel correspondant à une tension d'alimentation courante choisie inférieure à la tension d'alimentation maximale du circuit de commande.

Les instructions transmises comprennent au moins une clé d'ouverture pour autoriser l'accès à la mémoire non volatile et une instruction d'accès à la mémoire non volatile subséquente à l'autorisation reçue. Selon la présente invention, il est prévu que la clé d'ouverture soit une instruction prédéfinie transmise par modulation de la tension d'alimentation courante de sorte que cette dernière n'excède pas la tension d'alimentation maximale prédéfinie du circuit de commande.

La figure 1 représente un exemple de modulation de largeur d'impulsion utilisable pour la transmission d'instructions lors de la procédure d'accès de la mémoire non volatile de la montre selon un mode de mise en oeuvre préféré de la procédure d'accès de l'invention. La transmission des instructions et en particulier la transmission de la clé d'ouverture est réalisée par la transmission de données sérielles, effectuée à travers la ligne d'alimentation positive par une modulation directe d'une fréquence porteuse avec le signal de données. Dans cet exemple, l'amplitude de la fréquence porteuse est choisie de sorte qu'additionnée à la tension d'alimentation courante elle ne dépasse pas la tension d'alimentation maximale prédéfinie.

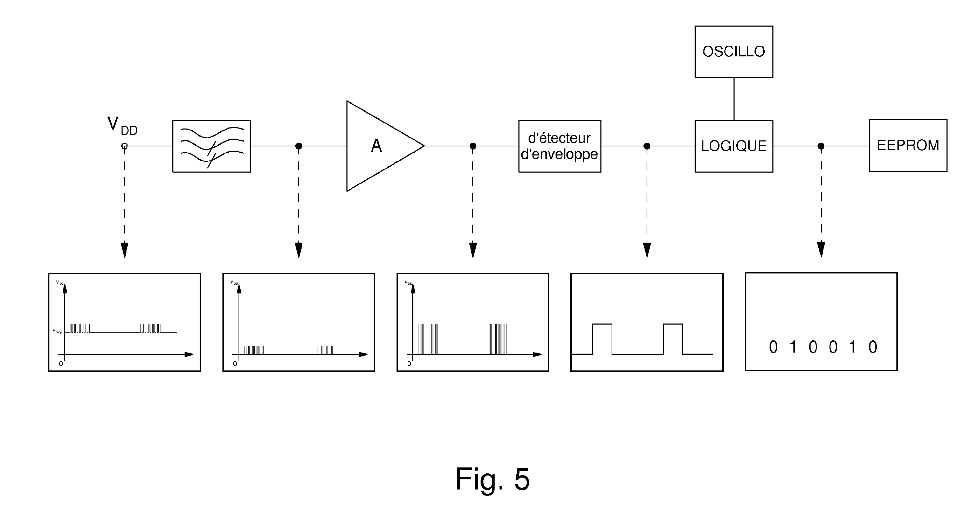

On notera qu'à titre de variantes, il est tout à fait envisageable de moduler directement la ligne d'alimentation négative, ou encore de prévoir une modulation partagée entre les deux lignes d'alimentation, l'une pouvant servir pour recevoir les données et l'autre un signal d'horloge ou encore tout autre répartition adéquate de la transmission des données envisageables sur les lignes d'alimentation. On notera que la solution présentée à la figure 1 reste une solution préférée dont un schéma fonctionnel de la détection des instructions transmises au niveau du circuit de commande sera expliqué en liaison avec la figure 5.

Toujours à titre de variantes, on notera qu'il est possible de transmettre directement les données par modulation de largeur d'impulsion sans ajout de porteuse bien qu'une telle solution soit moins sécurisée pour la transmission des données. Il est également possible d'envisager d'autres méthodes de modulation, comme par exemple une méthode de modulation par tout ou rien. On notera à cet effet que les instructions transmises soit par modulation de largeur d'impulsions, soit par modulation par tout ou rien, sont réalisées au moyen d'impulsions dont l'amplitude additionnée à la tension d'alimentation courante ne dépasse pas la tension d'alimentation maximale prédéfinie. On notera en outre que la modulation préconisée é la figure 1 ainsi que les variantes sus-présentées permettent avantageusement d'utiliser des mémoires de capacités développées dans la mesure où l'accès à la mémoire se fait directement à l'adresse souhaitée.

Bien que cela soit également possible, il a été remarqué cependant qu'une variante basée sur une méthode de modulation de position d'impulsions consistant dans l'envoi successif d'impulsions dont le temps entre deux impulsions permet de coder une instruction, ne se prêtait pas à l'utilisation d'une structure de mémoire développée pour des raisons de synchronisation et de facilité d'accès à une adresse mémoire. C'est pourquoi avec une telle technique de modulation, les mémoires non volatiles utilisées se limitent à l'utilisation d'un registre ou de quelques registres dans lesquels on vient pointer puis écrire successivement chaque bit d'information.

Les figures 2a et 2b représentent respectivement une instruction de programmation et la variation de courant correspondante pour vérifier l'exécution de l'instruction de programmation;

Dans le cadre de l'exemple représenté, une instruction de programmation comprend quatre premiers bits (wadd<3:0>) dits bits d'adresse car ils définissent l'adresse à programmer dans la mémoire, suivis par huit bits de données (din<7:0>). On notera que les bits de poids de fort (MSB) sont définis par wadd<3> et din<7> et que les bits de poids de faible (LSB) sont définis par wadd<0> et din<0>. Il est en outre prévu un bit P pour contrôler l'erreur du codage des bits de données entrantes (din) en vérifiant la parité. Ce bit P est appelé bit de parité.

On notera que lors d'une instruction de programmation, on écrit dans la mémoire d'abord les bits de poids faible avant d'écrire les bits de poids fort, tandis que lors d'une instruction de lecture, comme on le verra plus en détail avec les figures 3a et 3b, la séquence est inversée dans le sens où l'on lit d'abord les bits de poids fort puis les bits de poids faible.

Une fois l'instruction terminée, c'est-à-dire une fois la transmission des données terminée, l'alimentation du circuit continue à fournir une tension d'alimentation minimum prédéfinie, par exemple 2,5 V pendant un laps de temps minimum également prédéterminé, par exemple 10 ms, pour autoriser la programmation effective de la mémoire non volatile. Cette programmation est réalisée de manière classique au moyen d'un multiplicateur de tension permettant d'obtenir la haute tension nécessaire à la programmation des cellules de la mémoire.

A la figure 2b est représenté le haut courant d'alimentation, pouvant être de l'ordre de 50 à 100µA dans cet exemple, pendant l'écriture interne des bits de la mémoire, c'est-à-dire pendant le laps de temps prédéterminé (t_{WRITE}), qui sert de confirmation de la conformité des données transmises.

Comme cela a déjà été mentionné précédemment dans la description, la procédure d'accès à la mémoire comprend une clé d'ouverture, et de manière plus générale, une séquence de démarrage que nous allons détailler.

Avantageusement, il est prévu avant la transmission de la clé d'ouverture une étape préliminaire pour augmenter la sécurité d'accès à la mémoire. Cette étape préliminaire consiste en une procédure d'identification de la montre (WIP) qui permet l'activation de l'interface d'accès juste après la mise sous tension de la montre. Cette procédure d'identification de la montre consiste à écrire une adresse prédéfinie, par exemple l'adresse 10, avec une donnée prédéfinie, par exemple 0 sans nécessité d'autorisation d'accès.

Ensuite, pour commencer réellement la procédure d'accès à la mémoire, il est donc nécessaire de transmettre la clé d'ouverture pour autoriser l'accès à la mémoire. Avantageusement cette clé d'ouverture est une instruction de programmation comprenant une adresse à programmer prédéterminée et des bits de données prédéterminés. Selon une variante avantageuse, la clé d'ouverture consiste à fournir une adresse réservée à cet effet, par exemple l'adresse 9, et à écrire à cette adresse un mot représentant le coeur de la clé d'ouverture ou un code connu comprenant seulement 7 bits de données (din<7:1>), par exemple le code de la clé d'ouverture choisie pourra être 1010101, le dernier bit de données (din<0>) étant réservé comme bit d'autorisation d'accès à la mémoire, pour autoriser l'accès soit en écriture, i.e. en programmation, soit en lecture suivant la valeur de ce bit. Enfin la clé d'ouverture comprendra le bit de parité pour vérification. Une fois que la serrure est ouverte, les mots peuvent être alors programmés ou lus suivant l'accès autorisé autant de fois que nécessaire.

Nous allons maintenant fournir un exemple d'une procédure d'accès pour programmer la mémoire, exemple donné dans le tableau suivant et dont l'instruction de programmation est représentée à la figure 2a.

| **ETAPE** | **ADRESSE** **Wadd<3:0>** | **DONNEES ENTRANTES** **Din<7:0>** | **PARITE** **P** | **COMMENTAIRES** |
|---|---|---|---|---|
| Prélim. | 1010 | 00000000 | 0 | WIP |
| 1 | 1001 | 10101011 | 1 | Clé d'ouverture 1010101 + sélection écriture |
| 2 | 0111 | 10101101 | 0 | Programmation période d'inhibition 2 min, 45 ppm |
| 3 | 0101 | 00000110 | 0 | Programmation pas moteur 2x1 s, ... |
| 4 | 1001 | 00000000 | 0 | Clé de fermeture |

Comme vu précédemment, l'étape préliminaire, optionnelle, ou procédure d'identification de la montre, consiste à programmer l'adresse 10 avec le mot 0. Ensuite la première étape ou clé d'ouverture consiste à écrire à l'adresse 9, le mot "1010101" et à indiquer qu'un accès en écriture, i.e. en programmation, est autorisé par le dernier bit de données à 1. Il est ensuite prévu deux exemples (étapes 2 et 3) d'instructions de programmation consistant à programmer la période d'inhibition et le pas moteur, respectivement aux adresses 7 et 5 prévues à cet effet. Enfin, il est prévu avantageusement une dernière étape (4) consistant à transmettre une clé de fermeture par le biais d'une instruction de programmation de la même adresse que la clé d'ouverture, soit dans cet exemple de l'adresse 9, par un mot prédéfini, typiquement 0, pour remettre à zéro les données de l'adresse en vue d'une prochaine procédure d'accès à la mémoire, interdisant tout accès ultérieur à la mémoire avant cela.

Dans le même temps que se déroule cette procédure d'accès à la mémoire, il est prévu de comparer la durée de la procédure d'accès avec une valeur de dépassement de temps prédéfinie, et d'interrompre la procédure d'accès lorsqu'elle dure plus longtemps que la valeur de dépassement de temps. Cette valeur de dépassement de temps est calculée de préférence à partir de la mise sous tension.

En se référant maintenant aux figures 3a et 3b, nous allons décrire un exemple de procédure d'accès en lecture. Sur cette figure est représentée une instruction de lecture (figure 3a) par modulation de la tension d'alimentation pour lire le mot contenu dans la mémoire à l'adresse 7 ("0111") par l'observation de la variation correspondante du courant d'alimentation (figure 3b). La séquence est inversée, avec en premier les bits de poids de fort (MSB) et ensuite les bits de poids faible (LSB).

Les données stockées dans la mémoire non volatile sont vérifiés ou lus bit à bit par mesure du courant d'alimentation. Pour cela, le mot à lire est sélectionné avec l'adresse (wadd<3:0>) de ce mot, tandis que chaque bit dans le mot est sélectionné au moyen d'un bit d'adresse (badd<2:0>). Comme pour une instruction d'écriture, la chaîne de données d'une instruction de lecture, dans l'exemple représenté à la figure 3a, consiste en 13 bits de données sérielles. L'adresse du bit dans le mot pour une opération de lecture sera générée par un décodeur d'adresse de bit, qui a pour entrée la sortie du compteur de bits de données. Cela signifie qu'à chaque fois, un nouveau bit des données entrantes (din<7:0>) sera décalé pour pointer sur le bit suivant, du premier bit de poids fort (MSB) au dernier bit de poids faible (LSB). Avantageusement, le bit décalé à travers le registre à décalage est un bit "0" de sorte que la tension d'alimentation courante soit stable, i.e. ne soit pas modulée, lors de la lecture du bit correspondant à lire.

La lecture proprement dite s'effectue en observant le courant de consommation sur une borne de l'alimentation comme représentée à la figure 3b. Si la cellule ou le mot mémoire adressé contient un "1", un puits de courant I_{SINK} sera connecté entre les bornes d'alimentation (V_{DD} et V_{SS}), ce qui accroît sensiblement le courant d'alimentation de sorte qu'il est aisé de détecter si le bit lu est un "1" ou un "0" en observant cette consommation de courant. Après que le dernier bit à lire a été pointé, un bit additionnel est décalé et le circuit de commande transmet alors le bit de parité du mot lu.

Un exemple de la procédure d'accès en lecture est donnée avec le tableau suivant:

| **ADRESSE** **Wadd<3:0>** | **DONNEES ENTRANTES** **Din<7:0>** | **PARITE** **P** | **DONNEES SORTANTES** **Dout<7:0>+P** | **COMMENTAIRES** |
|---|---|---|---|---|
| 1010 | 00000000 | 0 | | WIP |
| 1001 | 10101010 | 0 | | Clé d'ouverture 1010101 + sélection lecture |
| 0111 | 10101101 | 1 | 10101101 + 1 | Lecture période d'inhibition 2 min, 45 ppm |
| 0101 | 00000110 | 0 | 00000110 +0 | Lecture pas moteur 2x1s, ... |
| 1001 | 00000000 | 0 | | Clé de fermeture |

Comme pour la procédure d'accès pour effectuer des opérations de programmation décrite précédemment, il est prévu de la même manière pour la procédure d'accès pour effectuer des opérations de lecture, avantageusement une étape préliminaire d'identification de la montre, suivie d'une première étape contenant la clé d'ouverture dans laquelle le dernier bit de données (din<7:0>), dans cet exemple "0", permet d'indiquer que l'accès demandé et autorisé est un accès en lecture. Les deux étapes suivantes sont deux exemples d'instructions de lecture des données écrites précédemment selon le protocole défini aux figures 3a et 3b. Enfin, on retrouve la transmission d'une clé de fermeture pour terminer cette procédure d'accès en interdisant tout accès ultérieur non autorisé à la mémoire.

On notera qu'avec cette procédure autorisant l'accès à la mémoire pour la programmation, voire pour la lecture, uniquement après réception d'une clé d'ouverture connue et avantageusement d'une procédure d'identification de la montre et d'une clé de fermeture, la procédure en écriture et/ou en lecture décrite ci-dessus permet d'obtenir une bonne immunité contre les signaux parasites susceptibles d'être reçus pour accéder frauduleusement ou par erreur à la mémoire.

La figure 5 représente de manière schématique un circuit de commande de la mémoire non volatile incorporé dans une montre selon l'exemple de réalisation proposé ci avant. Le circuit de commande comprend de manière classique un filtre passe-haut permettant de garder uniquement le signal haute fréquence porteur de l'information utile, i.e. les instructions de programmation et/ou de lecture de la mémoire, suivi d'un amplificateur pour augmenter l'amplitude du signal utile, puis d'un détecteur d'enveloppe pour dissocier la porteuse d'avec les bits d'informations transmis, et enfin d'un traitement numérique pour convertir les bits d'information reçus en une séquence de "1" et de "0" permettant de décoder les instructions.

Il a été remarqué que l'utilisation de l'oscillateur à quartz de la montre pour cadencer les opérations au niveau du circuit de commande intégré dans la montre présentait un temps de démarrage (de l'ordre de 0.5 à 2s) ou de mise en action ralentissant de manière non négligeable le temps de programmation totale d'une montre. C'est pourquoi avantageusement, il est prévu que le circuit de commande utilise pendant la procédure de programmation un oscillateur simple, du type oscillateur RC, comme générateur de signaux d'horloge, permettant un démarrage (de l'ordre de quelques µs) nettement plus rapide que lors de l'utilisation de l'oscillateur à quartz de la montre.

On comprendra que diverses modifications et / ou améliorations et / ou combinaisons évidentes pour l'homme du métier peuvent être apportées aux différents modes de réalisation de l'invention exposés ci-dessus sans sortir du cadre de l'invention défini par les revendications annexées. En particulier, on notera que cette procédure d'accès peut avantageusement être appliquée également à des registres volatiles utilisés généralement lors des tests horlogers pour vérifier la bonne marche de la montre.

## Revendications

1. Procédure d'accès à une mémoire non volatile pour montre, ladite montre comprenant deux bornes d'alimentation accessibles depuis l'extérieur de la montre, qui définissent une différence de potentiel correspondant à une tension d'alimentation courante, et un circuit de commande de la mémoire non volatile réalisé dans une technologie supportant une tension d'alimentation maximale prédéfinie, ladite procédure d'accès consistant à transmettre au dit circuit de commande de la mémoire non volatile par le biais d'au moins une des bornes d'alimentation de la montre:
a) une clé d'ouverture pour autoriser l'accès à la mémoire non volatile;
b) une instruction d'accès à la mémoire non volatile;
**caractérisée en ce que** ladite clé d'ouverture est une instruction prédéfinie transmise par modulation de ladite tension d'alimentation courante de sorte que cette dernière n'excède pas ladite tension d'alimentation maximale prédéfinie.

2. Procédure d'accès selon la revendication 1, **caractérisée en ce que** le circuit de commande utilise un oscillateur RC comme générateur de signaux d'horloge pendant la procédure de programmation.

3. Procédure d'accès selon l'une des revendications 1 ou 2, **caractérisée en ce que** les instructions sont transmises par modulation de largeur d'impulsion, impulsions dont l'amplitude additionnée à la tension d'alimentation courante ne dépasse pas la tension d'alimentation maximale prédéfinie.

4. Procédure d'accès selon l'une des revendications 1 à 3, **caractérisée en ce que** les instructions d'accès comprennent des instructions de programmation comprenant des bits d'adresse définissant une adresse à programmer dans la mémoire et des bits de données à programmer à l'adresse définie par les bits d'adresse contenus dans l'instruction de programmation.

5. Procédure d'accès selon la revendication 3, **caractérisée en ce que** la clé d'ouverture est une instruction de programmation comprenant une adresse à programmer prédéterminée et des bits de données prédéterminés.

6. Procédure d'accès selon la revendication 4, **caractérisée en ce que** la clé d'ouverture comprend en outre au moins un bit d'autorisation d'accès à la mémoire en programmation ou en lecture.

7. Procédure d'accès selon l'une des revendications 1 à 6, **caractérisée en ce que** les instructions d'accès comprennent des instructions de lecture comprenant des bits d'adresse définissant une adresse à lire dans la mémoire et des bits de données pour lire successivement chacun des bits de données de l'adresse définie par les bits d'adresse contenus dans l'instruction de lecture.

8. Procédure d'accès selon la revendication 7, **caractérisée en que** les bits de données d'une instruction de lecture sont déterminés de sorte que la tension d'alimentation courante ne soit pas modulée lors de la lecture effective de chaque bit de l'adresse à lire.

9. Procédure d'accès selon l'une quelconque des revendications précédentes, **caractérisée en ce que** les instructions sont transmises au moyen d'une porteuse dont l'amplitude additionnée à la tension d'alimentation courante ne dépasse pas la tension d'alimentation maximale prédéfinie de ladite technologie.

10. Procédure d'accès selon l'une quelconque des revendications précédentes, **caractérisée en ce qu'**il est prévu une étape préliminaire d'identification de la montre consistant en une instruction de programmation d'une adresse prédéterminée par des bits de données prédéterminés ne nécessitant pas d'autorisation d'accès.

11. Procédure d'accès selon l'une quelconque des revendications précédentes, **caractérisée en ce qu'**il est prévu une clé de fermeture consistant à effectuer une instruction prédéterminée interdisant tout accès ultérieur non autorisé à la mémoire.

12. Procédure d'accès selon la revendication 11, **caractérisée en ce que** la clé de fermeture est une instruction de programmation de l'adresse déterminée dans la clé d'ouverture par des bits de données déterminés différents de ceux programmer lors de l'exécution de la clé d'ouverture.

13. Procédure d'accès selon l'une quelconque des revendications précédentes, **caractérisée en ce qu'**il est prévu de comparer la durée de la procédure d'accès avec une valeur de dépassement de temps prédéfinie, et d'interrompre la procédure d'accès lorsqu'elle dure plus longtemps que la valeur de dépassement de temps.
